# EUROPEAN PATENT APPLICATION

(11) **EP 4 531 103 A1**
(43) Date of publication of application: **02.04.2025**
(21) Application number: 24195233.2
(22) Date of filing: 19.08.2024
(51) Int. Cl.: H01L 25/065, H01L 21/98, H01L 23/48, H01L 23/498, H01L 21/48, H01L 23/367

(54) **IC ASSEMBLIES WITH SELF-ALIGNMENT STRUCTURES HAVING ZERO MISALIGNMENT**

(30) Priority: 28.09.2023 US 202318374578
(71) Applicant: INTEL Corporation, Santa Clara, CA 95054 (US)
(72) Inventor: JUN, Kimin, Portland, OR 97229 (US); EID, Feras, Chandler, AZ 85226 (US); ELSHERBINI, Adel, Chandler, AZ 85248 (US); SOUNART, Thomas, Chandler, AZ 85226 (US); SHI, Yi, Chandler, AZ 85248 (US)
(74) Representative: HGF

(57) **Abstract**

A surface of an integrated circuit (IC) die structure or a host structure to which the IC die structure is to be bonded includes a biphilic surface for liquid droplet formation and droplet-based fine alignment of the IC die structure to the substrate. Hydrophobic regions can be self-aligned to hydrophilic regions of the biphilic surface by forming precursor metallization features within the hydrophobic regions concurrently with the formation of metallization features within the hydrophilic regions. Metallization features within the hydrophobic regions may then be at least partially removed as sacrificial to facilitate the formation of a hydrophobic surface. Metallization features within the hydrophilic regions may be retained and ultimately bonded to complementary features of another IC die structure or substrate structure.

## Description

### BACKGROUND

Integrated circuit (IC) die can be assembled with solder attachment techniques where solder features are brought into contact to join dies to a host structure. However, solder assembly techniques are difficult to scale below solder-bonded feature pitches that are in the tens of microns (e.g., 10-25 µm).

IC die may instead be assembled with hybrid bonding techniques where metallic bond sites of an IC die are directly interdiffused with corresponding metallic bond sites of a host structure. Such bonding is referred to as "hybrid" when a bond also forms between dielectric materials adjacent to the metallic bond sites. During a hybrid bonding process, components (e.g., dies) having corresponding bond sites, are brought together to interface with one another. At room temperature, dielectric material adheres sufficiently to establish an initial bond (e.g., due to Van der Waals forces). A thermal anneal may then fuse complementary metallic bond sites, and also increase the strength of the dielectric material bond interface. Hybrid bonding techniques are scalable well below bonded feature pitches of 1 µm. However, such nanometer pitch assembly techniques rely on nanometer scale (e.g., < 500 nm) fine alignment of IC die to the host structure, which can be time consuming and/or expensive to implement.

Techniques and architectures for hybrid bonding at nanometer scales in high volume manufacturing are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements. Further, where considered appropriate, reference labels have been repeated among the figures to indicate corresponding or analogous elements. In the figures:
FIG. 1 is a flow diagram illustrating self-alignment assisted assembly (SA3) methods for integrated circuit (IC) die structures, in accordance with some embodiments;
FIG. 2A is a cross-sectional view of trench patterning of a host structure, in accordance with some embodiments;
FIG. 2B is a plan view of the host structure illustrated in FIG. 2A, in accordance with some embodiments;
FIG. 3A is a cross-sectional view of metal bonding site features and adjacent metal alignment features of a host structure, in accordance with some embodiments;
FIG. 3B is a plan view of the host structure illustrated in FIG. 3A, in accordance with some embodiments;
FIG. 4A is a cross-sectional view of a selective recess of metal alignment features of a host structure, in accordance with some embodiments;
FIG. 4B is a plan view of the host structure illustrated in FIG. 4A, in accordance with some embodiments;
FIG. 5A is a cross-sectional view of hydrophobic features on a host structure, in accordance with some embodiments;
FIG. 5B is a plan view of the host structure illustrated in FIG. 5A, in accordance with some embodiments;
FIG. 6A is a cross-sectional view of a wafer or panel comprising a plurality of host structures, each host structure comprising a biphilic surface structure, in accordance with some embodiments;
FIG. 6B is a plan view of the wafer or panel illustrated in FIG. 6A, in accordance with some embodiments;
FIG. 7A is a cross-sectional view of IC die structures being coarse aligned and placed on liquid droplets confined to bonding regions, in accordance with some embodiments;
FIG. 7B is a plan view of aligning and placing the IC die structures of FIG. 7A, in accordance with some embodiments;
FIG. 8A is a cross-sectional view of a composite structure comprising IC die structures hybrid bonded to bonding regions of biphilic structures, in accordance with some embodiments;
FIG. 8B is a plan view of the composite structure shown in FIG. 8A, in accordance with some embodiments;
FIG. 9A is a cross-sectional view of a composite structure comprising IC die structures and a dielectric material therebetween, in accordance with some embodiments;
FIG. 9B is a plan view of the composite structure illustrated in FIG. 8A, in accordance with some embodiments;
FIG. 10 is a cross-sectional view of system comprising a heat sink and a host component assembled with a hybrid bonded composite structure further comprising an IC die structure, in accordance with some embodiments;
FIG. 11A is a cross-sectional view of trench patterning a host structure, in accordance with some alternative embodiments;
FIG. 11B is a plan view of the host structure illustrated in FIG. 11A, in accordance with some embodiments;
FIG. 12A is a cross-sectional view of selective recession of the metal alignment features in a host structure, in accordance with some alternative embodiments;
FIG. 12B is a plan view of the host structure illustrated in FIG. 12A, in accordance with some alternative embodiments;
FIG. 13A is a cross-sectional view of hydrophobic features formed on a host structure, in accordance with some alternative embodiments;
FIG. 13B is a plan view of the host structure illustrated in FIG. 13A, in accordance with some embodiments;
FIG. 14 illustrates a mobile computing platform and a data server machine employing a multi-chip package, in accordance with some embodiments; and
FIG. 15 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of systems and applications other than what is described in detail herein.

Reference is made in the following detailed description to the accompanying drawings, which form a part hereof and illustrate exemplary embodiments. Furthermore, structural and/or logical changes may be made without departing from the scope of claimed subject matter. Notably, directions and directional references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

As previously noted, hybrid bonding techniques offer advantages in the assembly of IC die structures to other IC die structures or some other host structure, such as a package substrate structure, interposer structure, or the like. Accordingly to embodiments described herein, an IC die structure may include any monolithic integrated circuit device that provides electrical, compute, memory, or similar functionality. An IC die structure may itself comprise more than one monolithic integrated circuit device. For example, an IC die structure may comprise two vertically stacked IC dies or two coplanar IC dies. IC dies within an IC die structure may be directly bonded to each other or coupled through interconnect features. IC die structures in accordance with embodiments herein may be referred to as "chiplets," "chiplet dies," "dice," "tiles," or "chips," for example. While the terms chiplet and IC die or chip may be used interchangeably, a fully functional ASIC is typically considered an IC die or chip while a chiplet or tile would have more limited functionality, for example supplementing one or more other IC chiplets that are to be part of the same multi-chiplet device. A chiplet or tile may, for example, be a wireless radio circuit, microprocessor core, electronic memory circuit, floating point gate array (FPGA), power management and/or power supply circuit, or include a MEMS device.

In the context of directly bonding IC die structures, self-alignment assisted assembly (SA3) may facilitate greater die-to-wafer hybrid bonding (D2W HB) throughput by reducing the fine alignment burden. In some exemplary SA3 processes, bonding regions are incorporated into "biphilic" or "heterogeneous" surface structures on either (or both) an IC die structure or (and) a host structure. As used herein, biphilic/heterogeneous surfaces have a high wettability contrast between their distinct regions. As described further herein, a high wettability contrast can be achieved by physical patterning (e.g., creating trenches around the bonding area to confine liquid via the canthotaxis effect), chemical patterning (e.g., depositing hydrophobic coatings to lower surface energy around the bonding area), or combinations of the two (e.g., creating trenches with hydrophobically coated sidewalls surrounding the bonding area).

Within a biphilic surface structure one region has high wettability relative to another region of low wettability. This wettability contrast can improve control of liquid droplet spreading such that a liquid droplet may be confined on a bonding site of either (or both) an IC die structure or (and) a host structure. Surface tension of the droplet acts to passively fine-align the IC die structure as the droplet evaporates, leaving the bonding regions in contact and ready for hybrid bonding. At room temperature, attractive surface forces between the dielectric regions on the IC die structure and a host structure may suffice to temporarily affix the two. A hybrid bond may be subsequently formed through application of pressure and/or elevated temperature to form and/or strengthen bonds between the metal features (e.g., copper pads) dispersed within surrounding dielectric material. Once bonded, the metal features form a composite metal feature that electrically interconnects an IC die structure and a host structure. In some embodiments, however, bonding may be dielectric-dielectric only or metal-metal only (e.g., for thermal applications or some RF applications).

With SA3 a bonder may pick and place an IC die structure upon a host structure relying on coarse alignment (e.g., ~ 25-50 um) alone, thereby enabling fast assembly. When a liquid droplet is confined to a bonding region between the IC die structure and the host structure, capillary forces and liquid surface tension induce alignment with high positional accuracy (e.g., < 200 nm) due to biphilic or transition structures on mating surfaces of the IC die structure and/or host structure. Such biphilic, heterogenous, or transition structures may therefore be more specifically referred to as "self-alignment features" or "SA3 features."

As described further below, to enable superior alignment performance during hybrid bonding of an IC die structure to a host structure, the IC die structure and/or host structure comprises a hydrophobic region self-aligned to a hydrophilic region. With self-alignment, error associated with lateral or rotational offset between hydrophobic and hydrophilic regions of a biphilic SA3 surface can be significantly reduced to have essentially zero misalignment. As described further below, hydrophobic regions can be self-aligned to hydrophilic regions by forming precursor metallization features where the hydrophobic regions will be eventually located. Such precursor metallization features may be formed concurrently with the formation of metallization features within the hydrophilic region. These precursor metallization features may then be at least partially removed prior to, or during, further processing responsible for forming a hydrophobic surface. The precursor metallization features may thereby locate the hydrophobic surface features without suffering misalignment to the hydrophilic region. Metallization features within the hydrophilic regions may be protected during further processing of the precursor metallization features, and ultimately bonded to complementary features of another IC die structure, package substrate structure or other host structure.

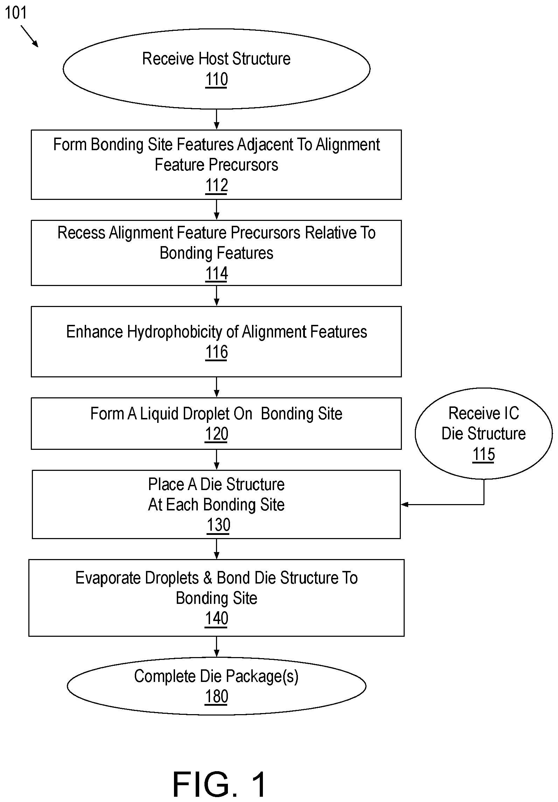

FIG. 1 is a flow diagram illustrating self-alignment assisted assembly methods 101 for integrated circuit (IC) die structures, in accordance with some first embodiments. According to methods 101, IC die structures are assembled to a host structure by practicing one or more SA3 techniques. Prior to assembly, an IC die structure and/or host structure is processed to form SA3 alignment features that are self-aligned to metallization features that are to be bonded during assembly. Methods 101 may be practiced, for example, to form one or more of the composite assemblies described elsewhere herein. Methods 101 are illustrated as including several discrete blocks to ensure clarity of description. However, in practice the number of blocks and/or order of such blocks may be modified without departing from the principles illustrated by methods 101.

Methods 101 begin at input 110 where a host structure is received. A host structure may be a portion of any wafer, panel, or strip, etc. that is suitable for the formation of bonding site features that are to be directly bonded, or otherwise interconnected, with one or more IC die structures. The bonding site features are formed within a bonding region of the host structure. The bonding region is integrated into one or more biphilic surfaces that are suitable for SA3 assembly.

In some embodiments, a host structure received at input 110 is a base (package) substrate structure, and an IC die structure that is to be assembled with the substrate structure is received at input 115. In other embodiments, the host structure received at input 110 is an IC die structure and another IC die structure that is to be assembled with the host IC die structure is received at input 115.

Methods 101 continue at block 112 where bonding site features are formed on the host structure. Adjacent to the bonding site features, alignment feature precursors are also formed at block 112. In exemplary embodiments, the alignment feature precursors are formed concurrently with the bonding site features. Alignment feature precursors may therefore be formed by substantially the same process employed to fabricate bonding site features. Advantageously, the same lithographic patterning process is practiced to concurrently pattern both bonding site features and the alignment feature precursors, ensuring there is no misalignment between them. Being concurrently formed, the alignment feature precursors may have substantially the same composition as the bonding site features. In some exemplary embodiments where the bonding site features comprise metallization, the alignment feature precursors comprise substantially the same metallization.

In some embodiments, block 112 comprises a damascene metallization process suitable for either backend metallization levels of an IC die structure or metallization levels of a package substrate structure. The metallization process may for example, comprise the formation of trenches into a dielectric material, filling of the trenches with metallization, and planarization of the metallization to expose dielectric material surrounding metallized trenches. For such embodiments, trenches corresponding to both bonding site features and alignment feature precursors may be defined with a single patterning process.

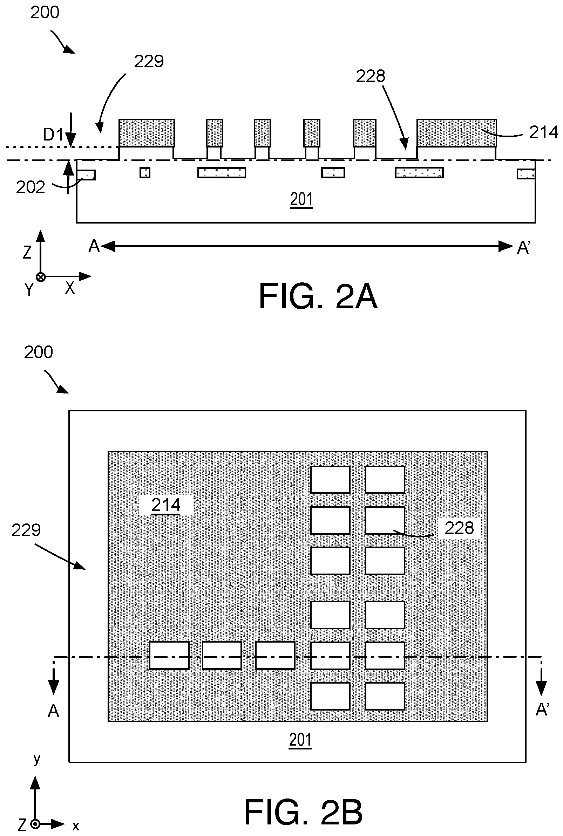

FIG. 2A is a cross-sectional view of trench patterning a host structure 200, in accordance with some embodiments. FIG. 2B is a plan view of host structure 200, in accordance with some further embodiments. The cross-sectional plane A-A' illustrated in FIG. 2A is demarked by a dot-dashed A-A' line in FIG. 2B.

Host structure 200 comprises one or more mask materials 214 over one or more substrate materials 201. Mask materials 214 are patterned with openings, and within these openings trenches 228 and 229 are etched to a depth D1 into substrate materials 201. As shown in FIG. 2B, trenches 228 are arrayed over an interior area of host structure 200 while trench 229 is within an exterior or peripheral area of host structure 200. In the illustrated example, trench 229 is continuous about a perimeter of trenches 228. However, alternative embodiments may include a plurality of trenches 229 that are laterally adjacent to one or more of trenches 228.

Substrate materials 201 may vary according to implementation. In some embodiments where host structure 200 is a package substrate structure, or package interposer structure, substrate materials 201 may include one or more structural material layers, such as semiconductor materials (monocrystalline), sapphire, or glass. Substrate materials 201 may include any materials found in an integrated circuit wafer, such as semiconductor materials (e.g., silicon, germanium, GaN, GaAs, InP, InGaAS, etc.), on-die interconnect layers (e.g., copper, aluminum, tantalum, other metals), and on-die dielectrics (e.g., silicon dioxide, carbon-doped silicon dioxide, silicon nitride, silicon carbide, etc.). For glass embodiments, the structural material may be predominantly silica (e.g., silicon and oxygen) and may further include one or more elements such as hydrogen, carbon and/or metals, such as, but not limited to copper, silver, gold, aluminum, beryllium, magnesium, calcium, strontium barium, or radium. Additional dopants (e.g., boron, phosphorus) may also be present in the structural material (e.g., borosilicate glass, etc.).

Substrate materials 201 may also include one or more levels of metallization features 202. Metallization features 202 may be embedded, for example, within a dielectric material. The dielectric material may have been built up on one or more side of a structural material layer, for example. Structural material layers may be retained or ultimately discarded so that substrate materials 201 may comprise only dielectric material and embedded routing metallization features 202.

Dielectric material may be an organic dielectric, such as, an epoxy resin, phenolic-glass, or a resinous film such as the GX-series films commercially available from Ajinomoto Fine-Techno Co., Inc.(ABF). Organic dielectric material may comprise epoxy resins (e.g., an acrylate of novolac such as epoxy phenol novolacs (EPN) or epoxy cresol novolacs (ECN)). In other examples, package dielectric material includes aliphatic epoxy resin, which may be monofunctional (e.g., dodecanol glycidyl ether), difunctional (butanediol diglycidyl ether), or have higher functionality (e.g., trimethylolpropane triglycidyl ether).

Host structure 200 may also comprise an inorganic dielectric material (e.g., comprising at least 20 atomic % of one or more of silicon, oxygen, or nitrogen). In some embodiments, the inorganic dielectric material is primarily silicon and oxygen (e.g., SiO₂), primarily silicon and nitrogen (e.g., Si₃N₂), or primarily silicon, oxygen and nitrogen (e.g., SiₓO_{y}Nₓ), any of which may further comprise one or more dopants, such as carbon. Inorganic dielectric materials are distinct from organic dielectrics (e.g., epoxy resins and phenolic-glasses), which have much higher carbon content and a higher percentage of carbon-hydrogen bonds. In some exemplary embodiments trenches 228 and 229 are fabricated into an inorganic dielectric material.

Substrate materials 201 may also include one or more IC die structures (not depicted). In some embodiments where host structure 200 is a package substrate or interposer, an IC die structure is embedded within dielectric material. In other embodiments, host structure 200 is an IC die structure. Such IC die structures may be fully functional ASICs, or may be chiplets or tiles of more limited functionality to supplement one or more other IC die structures that are to be part of the same multi-chip device. For embodiments where host structure 200 is an IC die structure, substrate materials 201 may include any of those materials typical of monolithically fabricated IC dies, such as, but not limited to, a device material layer and/or a silicon (e.g., monocrystalline) layer, and inorganic dielectric materials (e.g., comprising at least 20 atomic % of one or more of silicon, oxygen, or nitrogen).

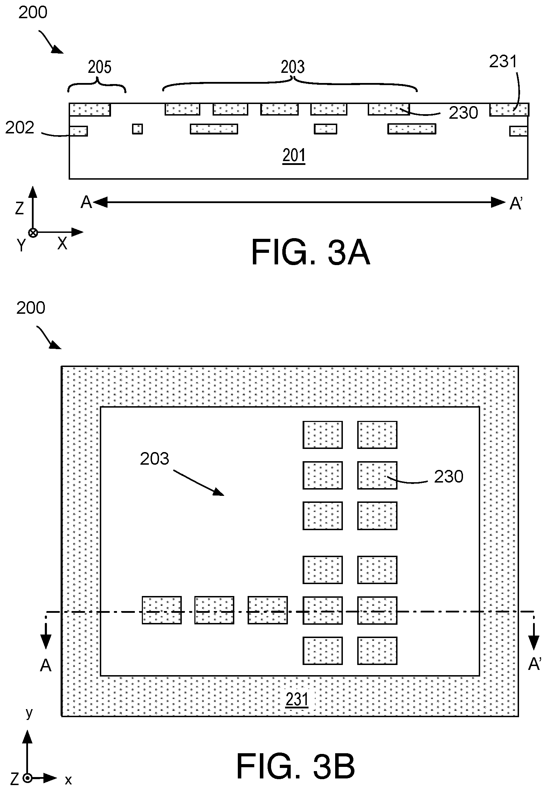

Any suitable metallization may be formed within trenches 228 and 229. In some embodiments, a barrier material, such as, but not limited to Ti, TiN, Ta, or TaN may be deposited as a liner within trenches 228 and 229. In some further embodiments, a fill metal is deposited over the barrier material. Exemplary fill metals comprise predominantly Cu, but may instead comprise predominantly another metal, such as W or Ru. FIG. 3A is a cross-sectional view following the formation of metallization within trenches 228 and 229. Bonding site features 230 and adjacent alignment feature precursors 231 are metallized, in accordance with some exemplary embodiments. Because trenches 228, 229 were etched to a same depth D1, the bottom surface of bonding site features 230 is substantially co-planar with the bottom surface of alignment feature precursors 231. As further shown in the plan view of FIG. 3B, all of bonding site features 230 are substantially surrounded by one continuous alignment feature precursor 231. As a result of the concurrent trench patterning, alignment feature precursor 231 has no misalignment with bonding site features 230.

Returning to FIG. 1, methods 101 continue at block 114 where the alignment feature precursors are further processed to convert them into alignment features suitable for self-alignment assisted assembly. This additional processing may be selective to the alignment feature precursors (e.g., performed while bonding site features are masked). In some embodiments, at least a portion of the alignment feature precursors are removed and/or recessed, for example to recover some portion of the topography associated with the previous trench patterning. The alignment feature precursors are advantageously recessed relative to the bonding site features. Depending on the material or chemical composition(s) of the alignment feature precursors, one or more etch processes may be employed at block 114. As noted above, a high wettability contrast can be achieved by physical patterning (e.g., creating trenches around the bonding area to confine liquid via the canthotaxis effect). Hence, recovering at least a portion of the trench at block 114 may be one aspect of fabricating SA3 alignment features from the precursors having zero misalignment with bonding site features.

The topographic features generated at block 114 may advantageously increase wettability contrast relative to a bonding region. Such topographic features (e.g., trenches) can change a liquid droplet's effective contact angle to greater than 90° and thereby alter the surface energy characteristics of the droplet. In some further embodiments, block 114 results in topographic features having significantly higher average surface roughness than in a bonding region. Block 114 may therefore comprises any surface texturing techniques, such as laser surface roughening.

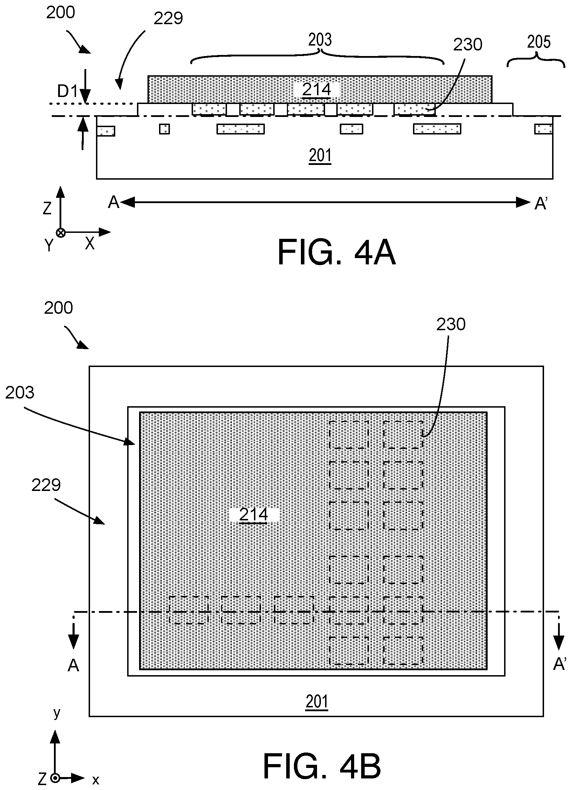

In the example further illustrated in FIG. 4A and FIG. 4B, while one or more mask materials 214 are within bonding region 203 to protect bonding site features 230, metallization is substantially removed from alignment feature precursors to form alignment features comprising trench 229. In some embodiments where metallization comprises both a barrier material and a fill metal, at least the fill metal is substantially removed within peripheral region 205. Any etch process suitable for a particular fill metal may be enlisted to recess and/or remove the fill metal. In some examples where the fill metal is predominantly Cu, host structure 200 may be exposed to a wet chemical etchant capable of dissolving Cu (or its oxides). A dry etch (e.g., atomic layer etch) and/or other plasma-based processes may also be enlisted in combination with, or in the alternative to, wet chemical etching. For example, following an etch of the fill metal a barrier material (e.g., Ta) may be removed with a plasma etch process. Other barrier material compositions, such as those comprising Ti, may be removed with either a wet chemical or dry etch process. With at least the fill metal substantially removed, trench 229 is again approximately depth D1. A bottom surface of trench 229 may therefore be substantially co-planar with bonding site features 230, as demarked in FIG. 4A by a dot-dashed line.

Surfaces of trench 229 may advantageously have a roughness greater than the surface roughness of an adjacent bonding region. For example, bonding site features 230, as protected by mask materials 214, may have a lower surface roughness (e.g., <15 nm average roughness for metallization and <1 nm average roughness for dielectric) while trench 229 has higher surface roughness (e.g., >50 nm average roughness). In some embodiments, the average surface roughness of a bottom of trench 229 is at least twice the average surface roughness of the surface of a bonding site features 230 and may be five, ten, or twenty times that of a bonding site features 230. As used herein, average roughness (or center line average) is as described in ASME B46.1. Average roughness is the arithmetic average of the absolute values of profile height deviations from a mean line that is recorded for an evaluation length. Average roughness may be measured, for example, with a profilometer comprising a stylus that is traversed over a surface or Atomic Force Microscopy(AFM). For trench 229 having a longitudinal length in a first dimension (e.g., coincident with y-axis in FIG. 4B), average roughness may be measured over a distance roughly 60-70% of the longitudinal length while remaining at about a centerline of a transverse width of trench 229 that is in a dimension substantially orthogonal to the first dimension (e.g., coincident with x-axis).

Notably, mask materials 214 can be expected to be somewhat misaligned relative to bonding site features 230 and trench 229, for example as illustrated in FIG. 4A, 4B. However, since the etch process recesses and/or removes the metallization selectively to exposed substrate materials 201 (e.g., an inorganic dielectric material), the location of trench 229 is independent of such mask misalignment, and therefore remains perfectly aligned to bonding site features 230.

Returning to FIG. 1, methods 101 continue at block 116 where hydrophobicity of the alignment features is enhanced. Hydrophobicity enhancement may include at least the formation of a hydrophobic material within a region at the periphery of a bonding region.

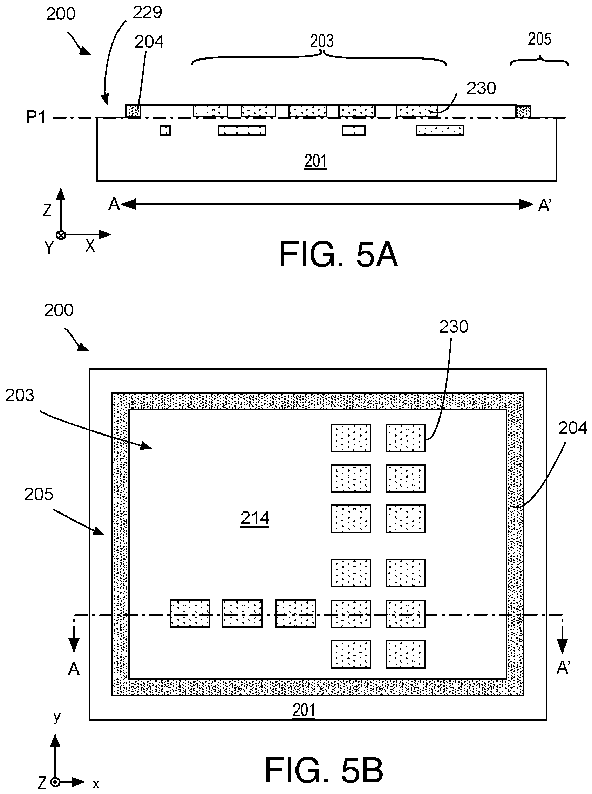

FIG. 5A and FIG. 5B illustrate cross-sectional and plan views of hydrophobic features 204 formed within peripheral region 205, in accordance with some embodiments. Hydrophobic features 204 ensure host structure 200 has biphilic or transition structures with sufficient wettability contrast between a bonding region comprising bonding site features 230 (e.g., of high wettability where a liquid droplet is to be formed), and the adjacent peripheral region 205 (e.g., of low wettability that will confine the liquid droplet). The liquid employed for self-alignment assisted assembly may vary (polar or non-polar, etc.). However, in exemplary SA3 embodiments employing water, the bonding region of high wettability is hydrophilic (i.e., inducing a water droplet to have a contact angle of less than 90°). A water droplet will therefore tend to spread out over the bonding region as the liquid minimizes its surface energy. The peripheral region 205 of low wettability is hydrophobic (i.e., inducing a water droplet to have a large contact angle of greater than 90°). A water droplet on the bonding region will therefore tend to minimize contact with peripheral region 205.

Co-planarity between bonding site features 230 and SA3 alignment features within peripheral region 205 is indicative of the alignment features having been derived from alignment feature precursors patterned concurrently with bonding site features 230. For embodiments where some portion of metallization is retained within trench 229, both the illustrated co-planarity and the presence of residual metallization (e.g., barrier material) are indicative of the alignment features having been derived from alignment feature precursors patterned concurrently with bonding site features 230. In exemplary embodiments illustrated by FIG. 5A, because hydrophobic features 204 are formed within trench 229, bottom surfaces of features 204 and bonding site features 230 are coplanar along an x-y plane P1. For embodiments where residual metallization (e.g., barrier material) is retained in trench 229, hydrophobic features 204 will be over, and in direct contact with, the residual metallization.

Features 204 may comprise any chemical coating or thin film material and/or topographic structure that enhances a hydrophobic boundary adjacent to one or more edges of bonding region 203. In some embodiments, features 204 comprise a self-assembled monolayer (SAM) material such as an alkyl or fluoroalkyl silane (e.g., ODS, FDTS), a thiol (e.g., hexadecane thiol), a phosphonic acid (e.g., octadecyl or perfluorooctane phosphonic acid), or an alkanoic acid (e.g., heptadecanoic acid). Other SAM embodiments may comprise disulfides, amines, azoles, amides, imides, pyridine derivatives, cyanoacrylate derivatives or other moieties which include a sulfur atom or a nitrogen atom. SAM reactions typically form monolayer molecules aligned with each other in a uniform manner. Such a molecule may be introduced in the vapor phase and "self-assemble" by forming a highly selective bond at the surface and orientating itself perpendicular to the face of the surface. However, non-SAM based materials or films are also possible. In some embodiments, features 204 are, or include, a polymer thin film such as a siloxane (e.g., PDMS and derivatives, HMDSO), a silazane (HMDS), a polyolefin (e.g., PP), or a fluorinated polymer (e.g., PTFE, PFPE, PFDA, C₄F₈ plasma polymerized films, etc.). In some advantageous embodiments, features 204 have a chemical composition with at least ten atomic percent (at. %) carbon or at least ten at. % fluorine.

Following the formation of hydrophobic feature(s) 204, host structure 200 retains a plurality of bonding site features 230, each of which is to bond with a corresponding IC die structure. In the example illustrated in FIG. 5A, features 204 are in direct contact with a sidewall of trench 229 (or in direct contact with a barrier material lining trench 229). Features 204 may however be upon any other surface of trench 229. As shown in FIG. 5B, features 204 substantially surround a pedestal or mesa of substrate materials 201 that comprise bonding site features 230. Features 204 may be adjacent to multiple non-parallel edges of a bonding region and/or formed on sidewalls of bonding regions according to any suitable technique(s). A conformal hydrophobic material layer may be formed on exposed surfaces of bonding regions, for example with either a spin coating or a conformal vapor deposition process. The conformal hydrophobic material layer may then be patterned with an anisotropic "spacer" etch.

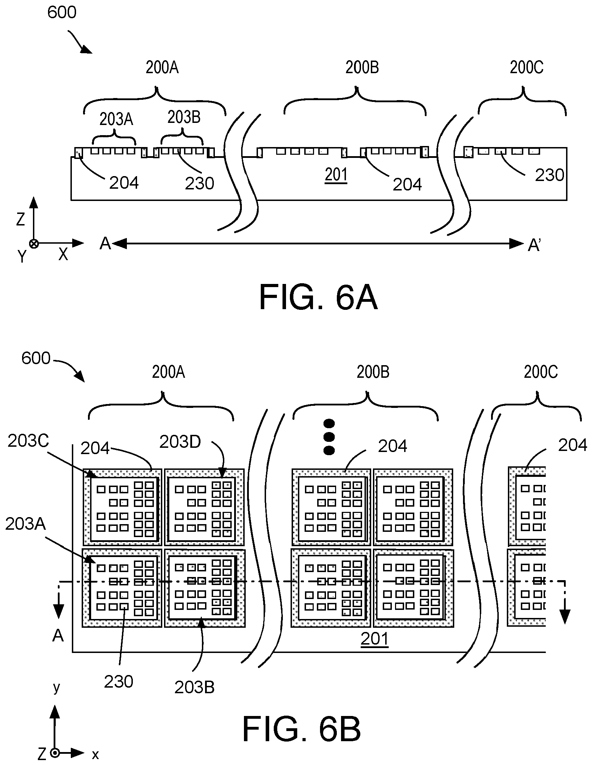

Host structure 200 may be part of a wafer or panel further comprising many such host structures. FIG. 6A is a cross-sectional view of an exemplary wafer (or panel) 600 comprising a plurality of aggregated host structures 200A, 200B, 200C. In the illustrated example, each host structure 200A-200C comprises a plurality of bonding regions 203A and 203B on a first (e.g., top) side of one or more substrate materials 201. In some exemplary embodiments, each of bonding region 203A and 203B are substantially as described above for bonding region 203. FIG. 6B further illustrates a plan view of a portion of wafer (or panel) 600. Four bonding regions 203A, 203B, 203C and 203D are within separate quadrants of host structure 200A. Each of the bonding regions is surrounded by a hydrophobic feature 204, which is within a trench (e.g., substantially as described above). In exemplary embodiments, one IC die is to be assembled upon each of the bonding regions 203A-203D. However, in other embodiments as few as one IC die may be assembled on each of host structures 200A-200C.

Returning to FIG. 1, methods 101 continue at block 120 where a liquid droplet is formed on each bonding region of the host structure. Any techniques suitable for the liquid, such as vapor condensation or direct liquid dispense (i.e., printing) may be practiced at block 120 as embodiments are not limited in this respect. In some exemplary embodiments, a water droplet is dispensed at block 120. However, alternative polar (e.g., alcohols) or non-polar (e.g., solvents) liquids may be dispensed at block 120 depending on the nature of the host structure's wettability contrast.

At input 115, a die structure is received. A liquid droplet may be formed on the IC die structure either in addition to the droplet formed on the bonding region at block 120, or as an alternative to the droplet formed at block 120. Methods 101 then continue at block 130 where the IC die structure received at input 115 is placed over a bonding region of the host structure prepared at block 120. The die structure received at input 115 may comprise a single IC die or may comprise any number of IC dies assembled (e.g., hybrid bonded) into a coplanar or 3D IC die structure. The IC die structure may, but need not, further comprise organic dielectric materials and/or metallization levels built up upon an IC die surface with a suitable semi-additive process (SAP).

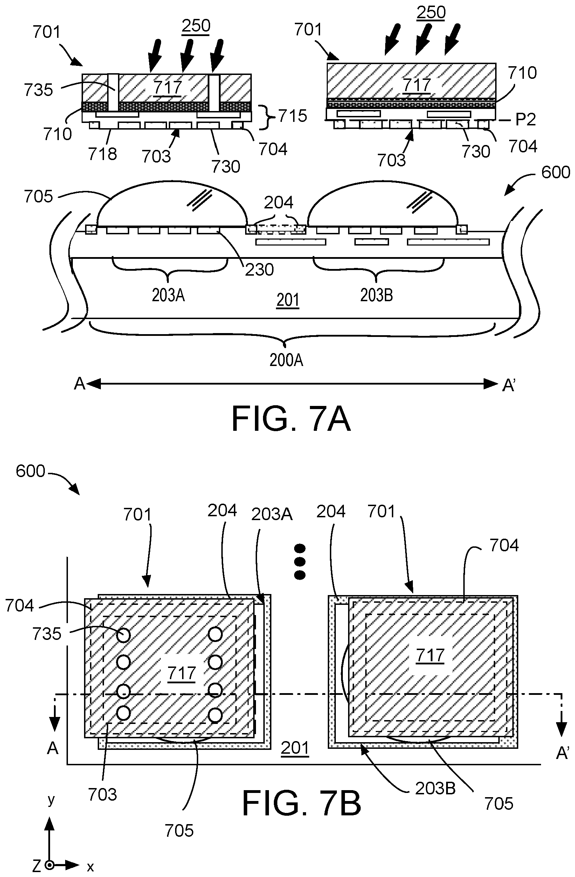

FIG. 7A is a cross-sectional view of IC die structures 701 undergoing an initial coarse alignment 250 to bonding site features 230. As so aligned, IC die structures 701 are placed upon liquid droplets 705 confined to bonding regions by the adjacent hydrophobic regions. Coarse alignment 250 may be performed, for example, with pick-and-place equipment. Such equipment may be capable of positional accuracy within 25-50 µm in each of the x-dimension and y-dimension, for example. FIG. 7B is a plan view of coarse alignment 250 and placement of IC die structures 701, in accordance with some embodiments. Some alignment error illustrated in FIG. 7B is to be corrected by liquid (e.g., water) droplet 705 during a passive fine alignment (e.g., via capillary forces, etc.) phase until the droplet evaporates. In exemplary embodiments, the fine alignment is advantageously to within 200 nm in each of the x-dimension and orthogonal y-dimension.

In the exemplary embodiments illustrated by FIG. 7A and FIG. 7B, IC die structures 701 each comprise an IC die substrate material 717, a device layer 710 in contact with IC die substrate material 717, and IC die metallization levels 715 over device layer 710. IC die structures may include through substrate vias (TSVs) 735 extending from device layer 710 and into IC die substrate material 717. Although the chemical composition of IC die substrate material 717 may vary with implementation, in exemplary embodiments IC die substrate material 717 is a silicon (e.g., monocrystalline) layer. IC die substrate material 717 may also be of alternative compositions, such as, but not limited to, germanium (Ge), silicon germanium alloys (SiGe), gallium arsenide alloys (GaAs), indium phosphide alloys (InP), gallium nitride alloys (GaN), silicon carbide alloys (SiC), etc. Device layer 710 comprises active devices (not depicted). In some embodiments, the active devices within device layer 710 are field effect transistors (FETs). The FETs may be of any architecture (e.g., planar, non-planar, single-gate, multi-gate, stacked nanosheet, etc.) and may have a feature pitch of 10-30nm, for example. Additionally, or in the alternative, device layer 710 may include active devices other than FETs. For example, device layer 710 may include electronic memory structures, spin valves, or the like.

IC die structures 701 comprise IC die metallization levels 715 on a front side of device layer 710. In exemplary embodiments, metallization levels 715 include die metallization features embedded within a dielectric material 718. Although IC die metallization features may have any composition(s) of sufficient electrical conductivity, in exemplary embodiments IC die metallization features are predominantly Cu. In other examples, metallization features are predominantly other than Cu, such as, but not limited to predominantly Ru, or predominantly W.

In some advantageous embodiments, IC die structures 701 comprise a biphilic surface structure corresponding to a complementary surface on host structure 200A. For IC die structures 701, a bonding region 703 comprises bonding site features 730 that are in an uppermost one of metallization levels 715. Bonding site features 730 may have any pitch compatible with bonding site features 230. In some exemplary embodiments, individual bonding site features 730 correspond to individual bonding site features 230 and have a feature pitch in the range of 100 nm to 10 µm, for example. Bonding site features 730 may have any suitable composition and may be of substantially the same composition as bonding site features 230 (e.g., a same metallization). Bonding site features 730 are embedded in a dielectric material 718, which may have any of the inorganic compositions described above for a host structure, for example.

Peripheral to bonding region 703, IC die structures 701 may further comprise topographic alignment features, for example substantially as described above for host structure 200 (and therefore host structure 200A). As illustrated, IC die structures 701 may have one or more trenches peripheral to bonding region 703 that are of a depth substantially equal to the thickness of bonding site features 730. IC die structures 701 further comprise one or more hydrophobic features 704 adjacent to bonding region 703. Features 704 may have any of the properties or characteristics discussed elsewhere herein for features 204. For example, a bottom surface of features 704 may be substantially co-planar with bonding site features 730 along plane P2. In some embodiments, bonding site features 730 and peripheral hydrophobic features 704 are fabricated according to any of the techniques discussed above for corresponding regions of host structure 200. For example, SA3 features on IC die structures 701 may be substantially self-aligned to bonding site features 730, as described above for host structure 200. The biphilic surface of host structure 200A and the biphilic surface of IC die structures 701 may therefore be substantially the same (as illustrated). Alternatively, biphilic surface of host structure 200A and the biphilic surface of IC die structures 701 may differ compositionally and/or structurally.

As further illustrated by dashed line in FIG. 7B, one or more hydrophobic features 704 substantially surround a perimeter of bonding region 703. Features 704 may be a single continuous material and/or structure with a hydrophobic surface. Alternatively, features 704 may comprise multiple discontinuous hydrophobic material segments delineating a perimeter about two or more edges of bonding region 703. Although FIG. 7A and FIG. 7B illustrate an example where two IC die structures 701 are placed adjacent to one another upon one host structure 200A, one or more IC die structures may be placed upon a particular host structure.

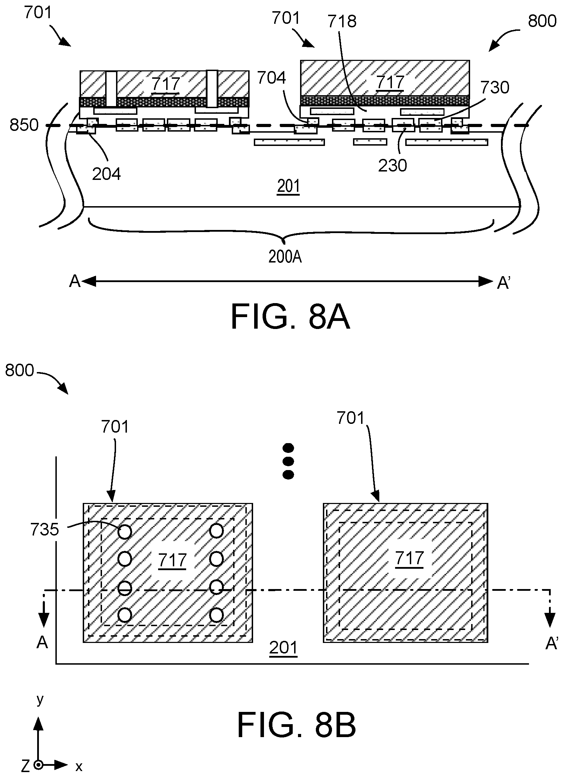

Returning to FIG. 1, methods 101 continue at block 140, where a liquid droplet between an IC die structure and a host structure is evaporated, bringing the IC die structure bonding site in direct contact with the host bonding sites. The IC die structure may then be bonded to the host structure according to any suitable bonding technique(s), such as a hybrid bonding technique. FIG. 8A illustrates an exemplary hybrid bonded composite structure 800 where IC die structures 701 are now in contact with host structure 200A along a bonding interface 850, denoted by a thick dashed line. As shown, bonding site features 230 within one bonding region are in direct contact with at least a portion of corresponding ones of bonding site features 730 of a complementary bonding region. Dielectric material of host structure 200A is likewise in direct contact with dielectric material of IC die structures 701. The magnitude of lateral offset between bonding site features 230 and 730 along bonding interface 850 is indicative of fine alignment tolerances associated with the assembly process and helps to demark bonding interface 850.

Individual ones of hydrophobic features 204 are similarly co-located with corresponding ones of features 704 on IC die structures 701. Hydrophobic features 204 may also be in direct contact with hydrophobic features 704 along bonding interface 850, although they may not interdiffuse or meld to form a unified composite structure even after a thermos and/or compression bonding process. As IC die structures 701 are bonded along a substantially planar bonding interface 850, IC die backside surfaces may not be co-planar if there is a difference between die structure thicknesses.

Returning to FIG. 1, methods 101 end at output 180 where any processes may be practiced to complete packaging. For example, a fill material may be deposited over a bonded IC die structure, and over portions of the host structure that is not occluded by an IC die structure. The fill material is advantageously a dielectric material (e.g., an inorganic dielectric material or an organic dielectric material) such as any of those previously described. In exemplary embodiments the fill material is deposited to a thickness at least equal to the thickness of the IC die structure. The fill material may be deposited by any technique known to be suitable for the chosen composition and thickness of material. In some embodiments, a dielectric fill material may be applied with a spin-on or spray-on process and subsequently cured. In other embodiments, a dielectric fill material may be deposited with a chemical vapor deposition (CVD) process. In still other embodiments, a dielectric fill material may be deposited with a molding process. Depending on the deposition process, the dielectric fill material may be planar along a length spanning the IC die structure and extending beyond an edge of the IC die structure, or not. The fill material may be planarized, for example with a chemical mechanical planarization (CMP) system or any other suitable grinder and/or polisher.

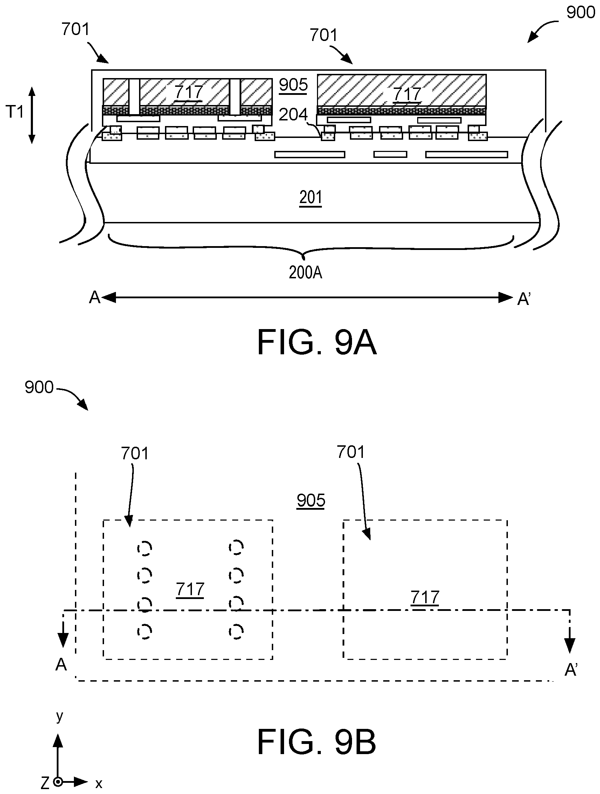

In the example illustrated in FIG. 9A and 9B, composite structure 900 further includes a dielectric material 905 over IC die structures 701. Dielectric material 905 also substantially backfills a gap between adjacent edge sidewalls of IC die structures 701. In some embodiments, dielectric material 905 is one or more of any of the inorganic dielectric compositions previously described. In some other embodiments, dielectric material 905 is one or more of any of the organic dielectric compositions previously described. As illustrated, dielectric material 905 is substantially planarized across IC die structures 701. Such planarization may be attributable to a dielectric deposition process and/or a post-deposition polishing or CMP process.

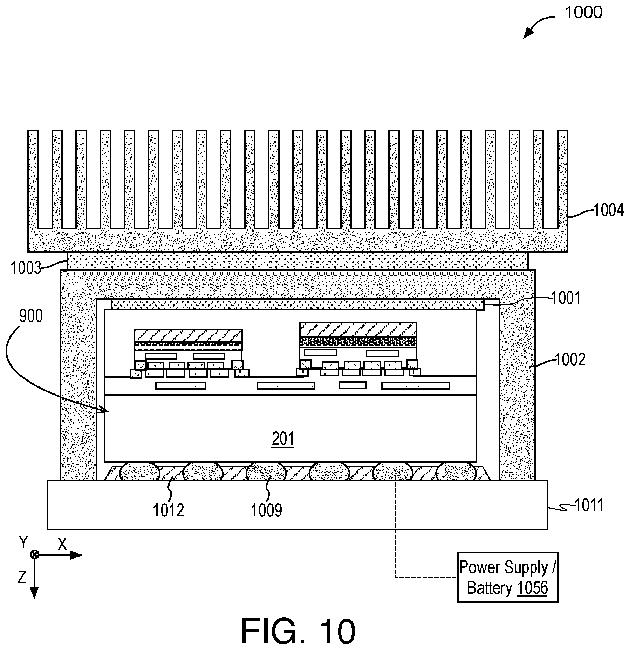

FIG. 10 is a cross-sectional view of system 1000 comprising a heat sink 1004 and a host component 1011 assembled with a hybrid bonded composite structure 900 further comprising an IC die structure and a host structure. At least one of the IC die and host structures has SA3 features that have been self-aligned to bonding site features, for example in accordance with one or more embodiments described herein. System 1000 may include any number of composite structures 900 mounted to host 1011 by way of interconnects 1009, which are optionally embedded in an underfill material 1012. Host 1011 may be a cored or coreless package substrate, interposer, or board (such as a motherboard), for example.

System 1000 further includes a power supply 1056 coupled to one or more of host 1011 (i.e., a board, package substrate, or interposer), composite structure 900, and/or other components of system 1000. Power supply 1056 may include a battery, voltage converter, power supply circuitry, or the like. System 1000 further includes a thermal interface material (TIM) 1001 over composite structure 900. TIM 1001 may include any suitable thermal interface material. System 1000 further includes an integrated heat spreader (IHS) and/or lid 1002 in contact with TIM 1001 and extends over composite structure 900. System 1000 further includes another TIM 1003 in contact with a top surface of IHS 1002. TIM 1003 may include any suitable thermal interface material and may be of the same composition as TIM 1001, or not. System 1000 includes a heat sink 1004 (e.g., an exemplary heat dissipation device or thermal solution) in contact with TIM 1003. System 1000 may be further integrated into a computer, such as a mobile device or server, for example.

FIG. 2A-10 illustrate exemplary embodiments where self-aligned SA3 alignment features have a topographic depth substantially equal to a thickness of adjacent bonding site features, for example because the SA3 alignment features are defined concurrently with the bonding site features. However, topographic alignment features deeper than bonding site features are also possible where multiple levels of overlapping metallization features are recessed and/or removed. With each metallization level being associated with some metallization feature thickness, a trench generated by removing substantially all of each metallization feature can have a depth substantially equal to the number of metallization levels removed multiplied by their respective thicknesses. Along with increasing SA3 alignment feature sidewall depth, such embodiments can also modulate alignment feature sidewall profile by controlling overlay between metallization features of different metallization levels.

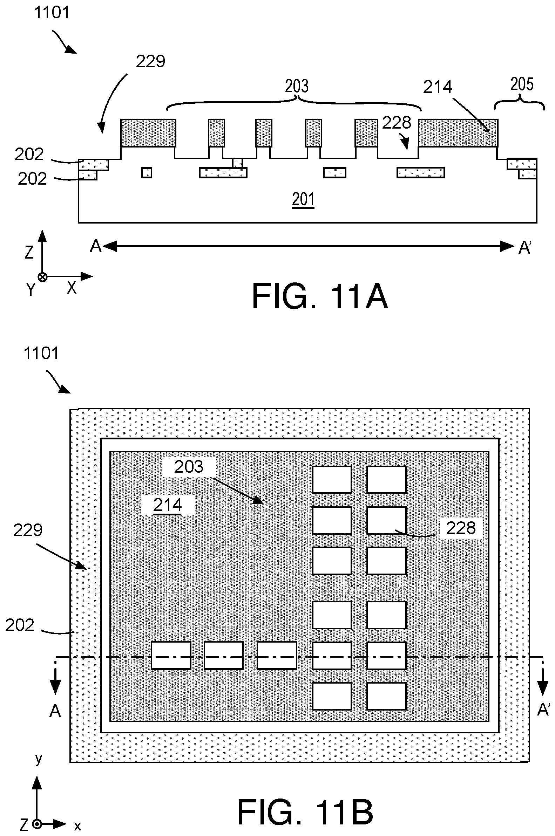

FIG. 11A-13B illustrate exemplary embodiments where self-aligned SA3 alignment features have a topographic depth substantially equal to a thickness of adjacent bonding site features summed with a thickness of one or more metallization levels below the bonding site features.

FIG. 11A is a cross-sectional view illustrating a patterning of trenches 228 and 229 for a top level of metallization of a host structure 1101. The trench patterning is to form bonding site features within bonding region 203 and is also to form alignment feature precursors within peripheral region 205. This patterning may be performed at block 112 of methods 101 (FIG. 1), for example substantially as described elsewhere herein. Host structure 1101 includes stacked metallization features 202 spanning multiple metallization levels, an upper one of which is exposed by trench 229. One or more of stacked metallization features 202 may be alignment feature precursors. As shown in FIG. 11A, at least an uppermost one of stacked metallization features 202 substantially surround a perimeter of bonding region 203.

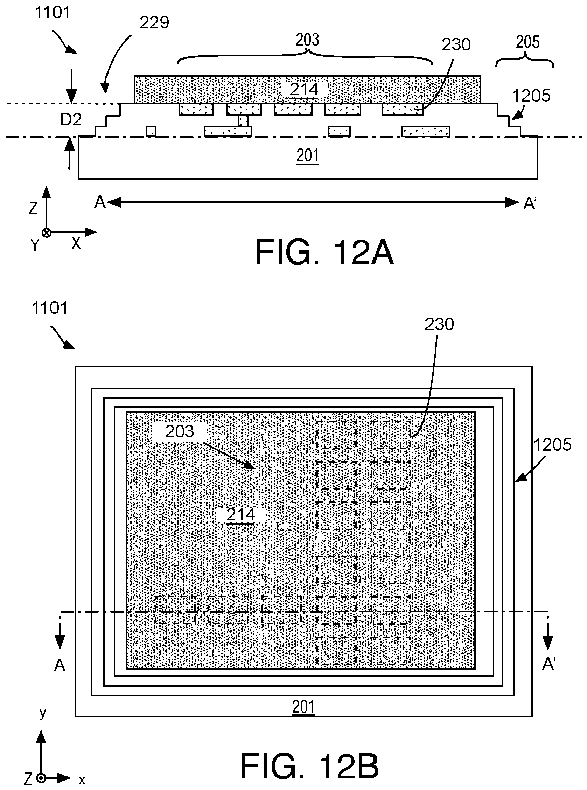

FIG. 12A further illustrates host structure 1101 following metallization of trenches to form bonding site features 230, for example substantially as described elsewhere herein. As further illustrated, while bonding site features 230 are protected by one or more mask materials 214, metallization within trenches in peripheral region 205 is substantially removed. In this example, the process practiced to remove the metallization not only removes metallization coplanar with bonding site features 230 but also removes both levels of stacked metallization features 202. Trench 229 is therefore not only recovered, but made deeper by the additional thickness of stacked metallization features 202 to reach a depth D2. Notably, a top portion of trench 229 remains self-aligned to bonding site features 230 while the additional depth of trench 229 may enhance wettability contrast between bonding region 203 and peripheral region 205.

Portions of trench 229 corresponding to stacked metallization features 202 may not be self-aligned to bonding site features 230. Overlay between stacked metallization features 202 may be utilized to control a sidewall profile 1205 of trench 229. Such sidewall profile control may be leveraged to further enhance wettability contrast between bonding region 203 and peripheral region 205. In the illustrated example, sidewall profile 1205 is a staircase because metallization features 202 were laterally offset in a first direction (e.g., along x-axis). In other embodiments, stacked metallization features 202 may be offset in an alternative manner, for example, to generate a reentrant sidewall profile that undercuts some portion of bonding region 203.

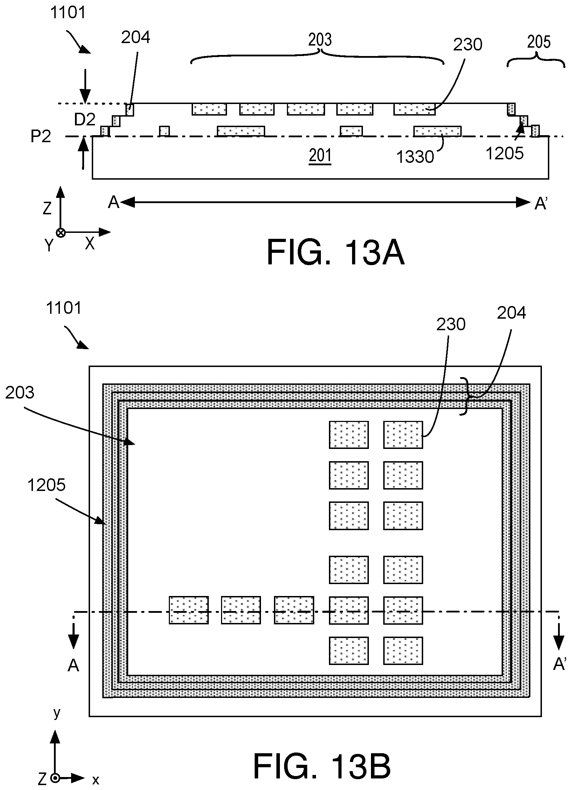

As further illustrated in FIG. 12B, trench 229 with sidewall profile 1205 surrounds bonding region 203. Accordingly, both of stacked metallization features 202 were sacrificial as alignment feature precursors. The alignment feature(s) fabricated by recessing metallization from alignment feature precursor(s) may be enhanced with further processing, for example at block 116 of methods 101 (FIG. 1). FIG. 13A and 13B illustrate exemplary embodiments where hydrophobic features 204 are formed within peripheral region 205. Structural aspects of hydrophobic features 204 may be modulated through control of sidewall profile 1205.

Both sidewall profile 1205 and depth D2 are indicative of a self-aligned process of fabricating SA3 alignment features. As shown in FIG. 13A, depth D2 is approximately equal to a thickness of bonding site features 230 summed with the corresponding thickness of an integer number of metallization levels. Accordingly, a bottom surface of the alignment features is substantially coplanar (along plane P2) with a bottom surface of a metallization features 1330 associated with a lower metallization level. Also, discrete offsets within sidewall profile 1205 that correspond with metallization level thicknesses indicate alignment features were derived from precursor features that are at least partially self-aligned to bonding site features.

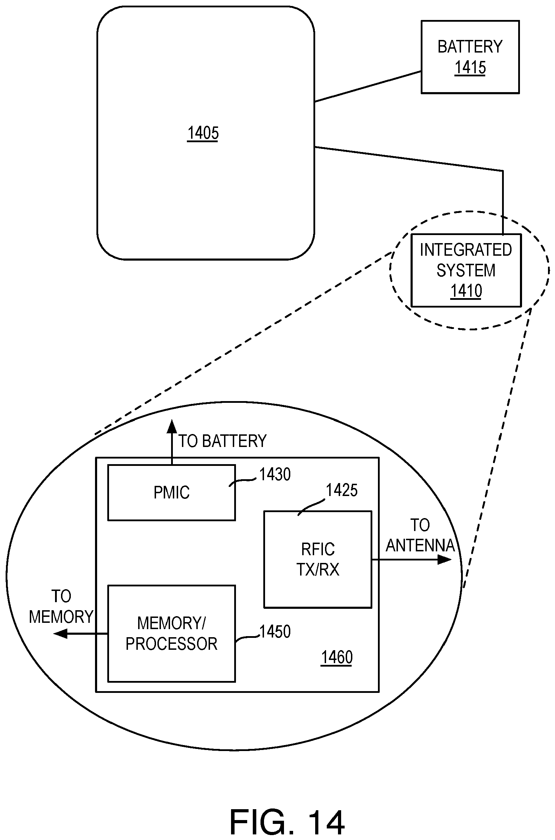

FIG. 14 illustrates an exemplary computer platform 1405 including a composite structure including a bonded IC die with biphilic surface structures proximal to a hybrid bond interface indicative of droplet-based fine alignment techniques. Platform 1405 may be a mobile computing platform and/or a data server machine, for example. A server machine may be any commercial server, for example, including any number of high-performance computing platforms disposed within a rack and networked together for electronic data processing. Platform 1405 may be any portable device configured for each of electronic data display, electronic data processing, wireless electronic data transmission, or the like. Platform 1405 may include a chip-level or package-level integrated system 1410, and a battery 1415. In some examples, the disclosed systems may be implemented in a disaggregated sub-system 1460.

Sub-system 1460 may include memory circuitry and/or processor circuitry 1450 (e.g., RAM, a microprocessor, a multi-core microprocessor, graphics processor, etc.), a power management integrated circuit (PMIC) 1430, and a radio frequency integrated circuit (RFIC) 1425 (e.g., including a wideband RF transmitter and/or receiver (TX/RX)). As shown, one or more IC dice, such as memory circuitry and/or processor circuitry 1450 may be co-packaged and/or co-assembled within a composite structure including an IC die having biphilic structures proximately to a hybrid bond interface, for example as described herein.

In some embodiments, RFIC 1425 includes a digital baseband and an analog front end module further comprising a power amplifier on a transmit path and a low noise amplifier on a receive path). Functionally, PMIC 1430 may perform battery power regulation, DC-to-DC conversion, etc., and so has an input coupled to battery 1415, and an output providing a current supply to other functional modules. As further illustrated in FIG. 14, in the exemplary embodiment, RFIC 1425 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1450 may provide memory functionality, high level control, data processing and the like for sub-system 1460.

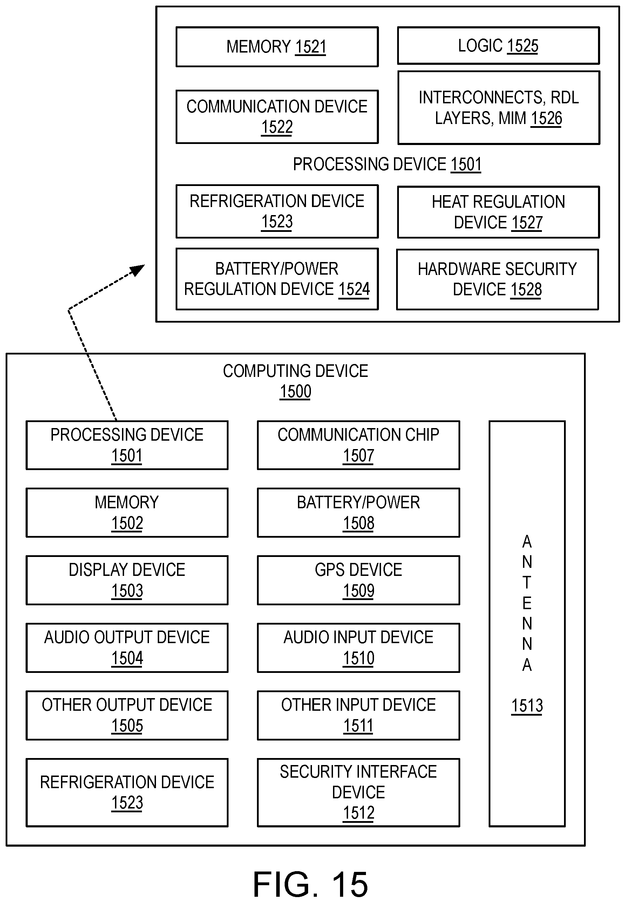

FIG. 15 is a block diagram of a cryogenically cooled computing device 1500 in accordance with some embodiments. For example, one or more components of computing device 1500 may include any of the devices or structures discussed elsewhere herein. A number of components are illustrated in FIG. 15 as included in computing device 1500, but any one or more of these components may be omitted or duplicated, as suitable for the application. In some embodiments, some of the components included in computing device 1500 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Additionally, in various embodiments, computing device 1500 may not include one or more of the components illustrated in FIG. 15, but computing device 1500 may include interface circuitry for coupling to the one or more components. For example, computing device 1500 may not include a display device 1503, but may include display device interface circuitry (e.g., a connector and driver circuitry) to which display device 1503 may be coupled.

Computing device 1500 may include a processing device 1501 (e.g., one or more processing devices). As used herein, the term processing device or processor indicates a device that processes electronic data from registers and/or memory to transform that electronic data into other electronic data that may be stored in registers and/or memory. Processing device 1501 may include a memory 1521, a communication device 1522, a refrigeration/active cooling device 1523, a battery/power regulation device 1524, logic 1525, interconnects 1526, a heat regulation device 1527, and a hardware security device 1528.

Processing device 1501 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1501 may include a memory 1502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing 1501 shares a package with memory 1502. This memory may be used as cache memory and may include embedded dynamic random-access memory (eDRAM) or spin transfer torque magnetic random-access memory (STT-M RAM).

Computing device 1500 may include a heat regulation/refrigeration device 1523. Heat regulation/refrigeration device 1523 may maintain processing device 1501 (and/or other components of computing device 1500) at a predetermined low temperature during operation. This predetermined low temperature may be any temperature discussed elsewhere herein.

In some embodiments, computing device 1500 may include a communication chip 1507 (e.g., one or more communication chips). For example, the communication chip 1507 may be configured for managing wireless communications for the transfer of data to and from computing device 1500. The term "wireless" and its derivatives may be used to describe circuits, devices, systems, methods, techniques, communications channels, etc., that may communicate data through the use of modulated electromagnetic radiation through a nonsolid medium.

Communication chip 1507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1507 may operate in accordance with other wireless protocols in other embodiments. Computing device 1500 may include an antenna 1513 to facilitate wireless communications and/or to receive other wireless communications (such as AM or FM radio transmissions).

In some embodiments, communication chip 1507 may manage wired communications, such as electrical, optical, or any other suitable communication protocols (e.g., the Ethernet). As noted above, communication chip 1507 may include multiple communication chips. For instance, a first communication chip 1507 may be dedicated to shorter-range wireless communications such as Wi-Fi or Bluetooth, and a second communication chip 1507 may be dedicated to longer-range wireless communications such as GPS, EDGE, GPRS, CDMA, WiMAX, LTE, EV-DO, or others. In some embodiments, a first communication chip 1507 may be dedicated to wireless communications, and a second communication chip 1507 may be dedicated to wired communications.

Computing device 1500 may include battery/power circuitry 1508. Battery/power circuitry 1508 may include one or more energy storage devices (e.g., batteries or capacitors) and/or circuitry for coupling components of computing device 1500 to an energy source separate from computing device 1500 (e.g., AC line power).

Computing device 1500 may include a display device 1503 (or corresponding interface circuitry, as discussed above). Display device 1503 may include any visual indicators, such as a heads-up display, a computer monitor, a projector, a touchscreen display, a liquid crystal display (LCD), a light-emitting diode display, or a flat panel display, for example.

Computing device 1500 may include an audio output device 1504 (or corresponding interface circuitry, as discussed above). Audio output device 1504 may include any device that generates an audible indicator, such as speakers, headsets, or earbuds, for example.

Computing device 1500 may include an audio input device 1510 (or corresponding interface circuitry, as discussed above). Audio input device 1510 may include any device that generates a signal representative of a sound, such as microphones, microphone arrays, or digital instruments (e.g., instruments having a musical instrument digital interface (MIDI) output).

Computing device 1500 may include a global positioning system (GPS) device 1509 (or corresponding interface circuitry, as discussed above). GPS device 1509 may be in communication with a satellite-based system and may receive a location of computing device 1500, as known in the art.

Computing device 1500 may include another output device 1505 (or corresponding interface circuitry, as discussed above). Examples include an audio codec, a video codec, a printer, a wired or wireless transmitter for providing information to other devices, or an additional storage device.

Computing device 1500 may include another input device 1511 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1500 may include a security interface device 1512. Security interface device 1512 may include any device that provides security measures for computing device 1500 such as intrusion detection, biometric validation, security encode or decode, managing access lists, malware detection, or spyware detection.

Computing device 1500, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

In first examples, an apparatus comprises a host structure comprising a plurality of metallization levels, an uppermost one of the metallization levels comprising one or more first metal features of a first thickness within a first region of the host structure further comprising an inorganic dielectric material. The first region is adjacent to a second region of the host structure, the second region comprising a recess of a depth substantially equal to a cumulative thickness of one or more of the metallization levels. The apparatus comprises an integrated circuit (IC) die structure coupled to the host structure. The IC die structure has a third region and an adjacent fourth region, the third region comprising an inorganic dielectric material and one or more second metal features of a second thickness. The second metal features are in direct contact with at least a portion of corresponding ones of the first metal features.

In second examples, for any of the first examples the depth of the recess is substantially equal to the first thickness.

In third examples, for any of the first through second examples the recess has greater average surface roughness than the first region, or wherein the second region comprises an organic material in contact with a sidewall of the recess.

In fourth examples, for any of the third examples the organic material has a composition of at least ten atomic percent carbon or at least ten atomic percent fluorine, the organic material at least partially filling the first and second recesses.

In fifth examples, for any of the first through fourth examples the first metal features comprise a fill metal and a barrier material between the fill metal and the inorganic dielectric material. The second region comprises the barrier material lining the recess, but the fill metal is substantially absent from the recess.

In sixth examples the plurality of metallization levels comprise a second metallization level below the first metallization level, the second metallization level having a third thickness. The depth of the recess is substantially equal to a sum of the first thickness and the third thickness.

In seventh examples, for any of the sixth examples a first sidewall portion of the recess spanning the first thickness is laterally offset from a second sidewall portion of the recess spanning the third thickness.

In eighth examples, for any of the first through seventh examples the fourth region comprises a second recess of a second depth substantially equal to the second thickness.

In ninth examples, for any of the first through eighth examples the second region is adjacent to two non-parallel edges of the first region.

In tenth examples, for any of the ninth examples the second region is substantially surrounding a perimeter of the first region.

In eleventh example, an apparatus comprises a host structure comprising one or more first metal features of a first thickness within a first region of the host structure further comprising an inorganic dielectric material. The first region is adjacent to a second region of the host structure. The apparatus comprises an integrated circuit (IC) die structure coupled to the host structure. The IC die structure has a third region and an adjacent fourth region, the third region comprising an inorganic dielectric material and one or more second metal features of a second thickness. The second metal features are in direct contact with at least a portion of corresponding ones of the first metal features along a plane of a bond interface. The second region comprises a first recess having a depth substantially equal to the first thickness. The fourth region comprises a second recess having a depth substantially equal to the second thickness.

In twelfth examples, for any of the eleventh examples the first recess comprises a trench substantially surrounding a perimeter of the first region and wherein the second recess comprises a trench substantially surrounding a perimeter of the fourth region.

In thirteenth examples, for any of the twelfth examples the first recess has greater average surface roughness than the first region, or wherein the second region comprises an organic material in contact with a sidewall of the first recess, and wherein the second recess has greater average surface roughness than the third region, or wherein the fourth region comprises an organic material in contact with a sidewall of the second recess.

In fourteenth examples, for any of the thirteenth examples the organic material has a composition of at least ten atomic percent carbon or at least ten atomic percent fluorine, the organic material at least partially filling the first and second recesses.

In fifteenth examples for any of the eleventh through fourteenth examples the first and second metal features comprise a fill metal and a barrier material between the fill metal and the inorganic dielectric material. The barrier material is lining the first and second recesses, but the fill metal is substantially absent from the first and second recesses.

In sixteenth examples, a method comprises receiving a first of an integrated circuit (IC) die structure or a package substrate structure comprising a first region with first metallization features within first trenches in an inorganic dielectric material, and a second region with one or more second metallization features within second trenches in the inorganic dielectric material. The method comprises removing at least a portion of the second metallization features from the second trenches. The method comprises aligning the first of the integrated circuit (IC) die structure or the package substrate structure with a second of an integrated circuit (IC) die structure or a package substrate structure based on a wettability contrast between the first and second regions. The method comprises bonding the first of the IC die structure or the package substrate structure with a second of the IC die structure or the package substrate structure, wherein the bonding comprises contacting the first metallization features with corresponding metallization features.

In seventeenth examples, for any of the sixteenth examples the method comprises forming, within the inorganic dielectric material, the first trenches and the one or more second trenches, depositing metallization into both the first and second trenches, and forming the first and second metallization features by planarizing the metallization until the inorganic material is exposed.

In eighteenth examples for any of the seventeenth examples removing at least a portion of the second metallization features from the second trenches comprises a wet chemical etch of the metallization.

In nineteenth examples, for any of the seventeenth through eighteenth examples depositing the metallization comprises forming a barrier layer in the first and second trenches, and plating copper over the barrier layer. Removing at least a portion of the second metallization features comprises removing substantially all of the copper from the second trenches.

In twentieth examples, for any of the sixteenth through nineteenth examples the method comprises forming a hydrophobic material in contact with at least a sidewall of the second trenches after removing at least a portion of the second metallization features.

It will be recognized that principles of the disclosure are not limited to the embodiments so described, but instead can be practiced with modification and alteration without departing from the scope of the appended claims. The above embodiments may include the undertaking only a subset of such features, undertaking a different order of such features, undertaking a different combination of such features, and/or undertaking additional features than those features explicitly listed. The scope of the embodiments should, therefore, be determined with reference to the appended claims, along with the full scope of equivalents to which such claims are entitled.

## Claims

1. An apparatus, comprising:
a host structure comprising a plurality of metallization levels, an uppermost one of the metallization levels comprising one or more first metal features of a first thickness within a first region of the host structure further comprising an inorganic dielectric material, wherein the first region is adjacent to a second region of the host structure, the second region comprising a recess of a depth substantially equal to a cumulative thickness of one or more of the metallization levels; and
an integrated circuit (IC) die structure coupled to the host structure, wherein the IC die structure has a third region and an adjacent fourth region, the third region comprising an inorganic dielectric material and one or more second metal features of a second thickness, and wherein the second metal features are in direct contact with at least a portion of corresponding ones of the first metal features.

2. The apparatus of claim 1, wherein the depth of the recess is substantially equal to the first thickness.

3. The apparatus of any one of claims 1-2, wherein the recess has greater average surface roughness than the first region, or wherein the second region comprises an organic material in contact with a sidewall of the recess.

4. The apparatus of claim 3, wherein the organic material has a composition of at least ten atomic percent carbon or at least ten atomic percent fluorine, the organic material at least partially filling the recess.

5. The apparatus of any one of claims 1-4, wherein:
the first metal features comprise a fill metal and a barrier material between the fill metal and the inorganic dielectric material; and
the second region comprises the barrier material lining the recess, but the fill metal is substantially absent from the recess.

6. The apparatus of any one of claims 1-5, wherein:
the plurality of metallization levels comprise a second metallization level below the uppermost metallization level, the second metallization level having a third thickness; and
the depth of the recess is substantially equal to a sum of the first thickness and the third thickness.

7. The apparatus of claim 6, wherein a first sidewall portion of the recess spanning the first thickness is laterally offset from a second sidewall portion of the recess spanning the third thickness.

8. The apparatus of any one of claims 1-7, wherein the fourth region comprises a second recess of a second depth substantially equal to the second thickness.

9. The apparatus of any one of claims 1-8, wherein the second region is adjacent to two non-parallel edges of the first region.

10. The apparatus of claim 9, wherein the second region is substantially surrounding a perimeter of the first region.

11. The apparatus of any one of claims 1-10, wherein the second metal features are in direct contact with at least a portion of corresponding ones of the first metal features along a plane of a bond interface.

12. The apparatus of any one of claims 1-7, wherein the recess is a first recess comprising a trench substantially surrounding a perimeter of the first region and wherein a second recess comprising a trench substantially surrounds a perimeter of the fourth region.

13. The apparatus of claim 12, wherein the first recess has greater average surface roughness than the first region, or wherein the second region comprises an organic material in contact with a sidewall of the first recess, and wherein the second recess has greater average surface roughness than the third region, or wherein the fourth region comprises an organic material in contact with a sidewall of the second recess.

14. The apparatus of claim 13, wherein the organic material has a composition of at least ten atomic percent carbon or at least ten atomic percent fluorine, the organic material at least partially filling the first and second recesses.

15. The apparatus of any one of claims 12-14, wherein:
the first and second metal features comprise a fill metal and a barrier material between the fill metal and the inorganic dielectric material; and
the barrier material is lining the first and second recesses, but the fill metal is substantially absent from the first and second recesses.
